# EUROPÄISCHE PATENTSCHRIFT

(11) **EP 1 532 691 B1**
(45) Veröffentlichungstag und Bekanntmachung des Hinweises auf die Patenterteilung: **11.02.2009**
(21) Anmeldenummer: 03753262.9
(22) Anmeldetag: 29.08.2003
(51) Int. Cl.: H01L 31/0216

(54) **MINIMIERUNG VON LICHTVERLUSTEN UND ELEKTRONISCHE ABSCHIRMUNG AN INTEGRIERTEN FOTODIODEN**
MINIMISATION OF LIGHT LOSSES AND ELECTRONIC SHIELDING ON INTEGRATED PHOTODIODES
REDUCTION A UN MINIMUM DES PERTES DE LUMIERE ET BLINDAGE ELECTRONIQUE DE PHOTODIODES INTEGREES

(30) Priorität: 29.08.2002 DE 10239643; 29.08.2002 DE 10239642
(43) Veröffentlichungstag der Anmeldung: 25.05.2005
(73) Patentinhaber: X-FAB Semiconductor Foundries AG, 99097 Erfurt (DE)
(72) Erfinder: BACH, Konrad, 99189 Tieftal (DE)
(74) Vertreter: Leonhard, Frank Reimund
(86) Internationale Anmeldenummer: PCT/DE2003/002874
(87) Internationale Veröffentlichungsnummer: WO 2004/021453

(56) Entgegenhaltungen:
- EP-A- 0 866 503
- JP-A- 10 189 926
- US-A- 6 025 585
- US-A- 6 043 115
- US-A1- 2001 045 568
- US-B1- 6 407 440
- PATENT ABSTRACTS OF JAPAN vol. 1998, no. 05, 30. April 1998 (1998-04-30) -& JP 10 027922 A (DENSO CORP), 27. Januar 1998 (1998-01-27)
- PATENT ABSTRACTS OF JAPAN vol. 018, no. 406 (E-1585), 28. Juli 1994 (1994-07-28) -& JP 06 120553 A (NEW JAPAN RADIO CO LTD), 28. April 1994 (1994-04-28)

## Beschreibung

Die Erfindung bezieht sich auf CMOS/BiCMOS-Technologien mit integrierten fotoempfindlichen Strukturen, vorzugsweise Fotodioden, speziell auf den Schichtaufbau von Abdeckschichten und elektrisch leitfähigen transparenten Schichten zur elektronischen Abschirmung der fotoelektrisch aktiven Regionen.

Integrierte Schaltkreise moderner CMOS-Technologien haben als essentiellen Bestandteil durch pn-Übergänge isolierte Gebiete unterschiedlicher Leitfähigkeit, die als Drain/Source, Wannen, bzw. integrierte Widerstände wirken. Es bietet sich an, diese dem Prozess immanenten Diodenstrukturen auch als Detektoren für optische Signale zu verwenden (Fotodioden) und damit auf einem Chip einen Sensor und Auswerteelektronik zu integrieren. Das Dokument JP-A-10189926 beschreibt eine Halbleitervorrichtung mit Passivierungsschichten.

Mittlerweile ist es Stand der Technik, solche Dioden zu integrieren. Insbesondere Kamerachips auf CMOS-Basis sind echte Alternativen gegenüber CCD-Kameras. Das einfallende Licht erreicht im allgemeinen auch die Diodenstruktur im Silizium-Chip, da die über dem Silizium liegenden isolierenden Deckschichten aus Siliziumoxid und Siliziumnitrid bestehen, die für Licht im sichtbaren Bereich transparent sind, wie auch spezielle elektrisch leitfähige Schichten. Letztere sind notwendig, um z.B. bei Optokopplern kapazitive Einkopplungen zu vermeiden, die ansonsten zu Signalstörungen führen.

Ein wesentliches Problem liegt nun darin, dass die auf der fertig prozessierten Siliziumscheibe (Wafer) liegenden Schichten in ihrer Dicke nicht auf eine maximale optische Transparenz angepasst sind, so dass es zu Intensitätsverlusten kommt. Im Allgemeinen liegen 3 bis 5 und teilweise noch mehr verschiedene Schichten übereinander, die eine Gesamtschichtdicke von 1 bis 3 µm und mehr ergeben. Die Dicke dieses Schichtaufbaus liegt also in der Größenordnung der Lichtwellenlängen (bis einige Vielfache), so dass infolge von Interferenzen an dünnen Schichten je nach Wellenlänge und aktueller Schichtdicke der Anteil des durchgehenden Lichtes reduziert sein kann. Speziell zum quantitativen Detektieren monochromatischen Lichtes kann bereits die normale Prozesstoleranz der Dicke bei der Schichtabscheidung (± 10%) auf einer einzelnen Siliziumscheibe Gebiete maximaler Transmission und auch Gebiete maximaler Reflexion ergeben, d.h. die transmittierte Lichtmenge einer monochromatischen Lichtquelle, die in der Fotodiode ankommt, kann bezogen auf eine Siliziumscheibe bis 40% schwanken.

Es ist Aufgabe der Erfindung, im Bereich der fotoempfindlichen und vor fremder elektrischer Einkopplung zu schützenden Strukturen der Schaltung die Kombination von Abdeckschichten und transparenten elektrisch leitfähigen Schichten so zu gestalten, dass die Lichtverluste durch Interferenz weitestgehend vermindert werden (Maximierung der Transmission). Eine größere Gleichmäßigkeit der Lichttransparenz in der Verteilung über eine einzelne Siliziumscheibe, insbesondere auch bezogen auf verschiedenen Siliziumscheiben untereinander soll erreicht werden.

Mit der Erfindung ist eine Verbesserung der CMOS/BiCMOS-Technologien mit integrierten fotoempfindlichen Strukturen und elektrischer Abschirmung bezüglich Kosten durch Ausbeutesteigerung und durch möglichst geringen Fertigungsmehraufwand erreicht.

Die Aufgabe wird so gelöst, dass dafür gesorgt wird, dass über den Gebieten der fotoempfindlichen Strukturen ein Doppelschichtsystem gebildet wird (Anspruch 1). Es beinhaltet eine aus der im Prozess zuletzt folgende Isolatorschicht eines üblichen Abschlussschichtsystems und eine dieser folgenden transparenten, elektrisch leitfähigen Schicht. Sie sind so abgestimmt, dass einzelne Dicken vorhanden sind, die in der Summe einer "optischen Dicke" des Schichtsystems mit maximaler Transparenz entspricht, bei einem verminderten Dickentoleranzeinfluss.

Über den entsprechenden lichtempfindlichen Gebieten, insbesondere Fotodioden oder Fotogates, wird also ein nur aus zwei Schichten bestehendes Schichtsystem angeordnet, dessen optische Dicke (Brechzahl * Schichtdicke) auf die Wellenlänge abgestimmt wird. Die Transmission wird maximal, zumindest stark erhöht (D = λ/4 bzw. ein ungerades Vielfache davon) und eine unvermeidliche Toleranz der Dicke nach dem Abscheiden (i.A. ± 10%) führt noch nicht von einer Verstärkung zu einer Auslöschung des durchgehenden Lichtes (Transmission).

In der von der Erfindung ermöglichten Fertigung sieht das so aus, dass der CMOS- bzw. BiCMOS-Prozess unverändert bis einschließlich der letzten Metallisierung ablaufen kann. Ein üblicherweise danach abzuscheidendes Passivierungs-Schichtsystem erhält mehrere Aufgaben: Eine elektrische Isolation zur Umwelt, einen mechanischen Schutz, einen Schutz gegenüber Feuchte und gegebenenfalls auch eine Getterwirkung (z.B. durch eingebauten Phosphor).

Bespielhaft wird von einem solchen Doppelschichtsystem der Passivierung, mit einer ersten Schicht aus Siliziumoxinitrid, gefolgt von einer Schicht aus Siliziumnitrid ausgegangen. In der erfindungsgemäßen Prozessfolge (Anspruch 4, Anspruch 13) wird das Siliziumoxinitrid standardgemäß abgeschieden (falls dieses "gettern" soll, können Getterzentren eingebracht werden). Danach erfolgt ein fotolithografischer Prozess, bei dem die lichtempfindlichen Gebiete freigelegt werden. Dabei werden im Bereich der fotoempfindlichen Strukturen alle Schichten über der Siliziumoberfläche entfernt, was bedingt durch Grenzfläche SiO₂/Si ausreichend präzise möglich ist.

Es versteht sich, dass Öffnungen der Fotomaske einen hinreichend großen Abstand zu Metall-Leitbahnen und zu an die Oberfläche stoßenden pn-Übergängen haben (pn-Übergänge dürfen nicht freigelegt werden).

Nach dem Entfernen der Lackmaske wird dann die das neue Passivierungssystem komplettierende Siliziumnitridschicht mit einer definierten Schichtdicke abgeschieden, die zu einer Dicke der später noch aufzubringenden transparenten elektrisch leitfähigen Schicht passt.

Zunächst folgt die Öffnung der Kontakte in der Passivierungsschicht, für die Verbindung zwischen der oberen Metallschicht und der abschirmenden Schicht.

Nach Öffnen der Kontakte erfolgt die Abscheidung der transparenten leitfähigen Schicht, gefolgt von deren Strukturierung. Die optische Dicke des Schichtsystems aus Passivierungschicht und transparenter leitfähiger Schicht wird in an sich bekannter Weise so gewählt, dass für einen gegebenen Lichtwellenlängenbereich eine hohe, insbesondere maximale Transmission auftritt.

Bei Bedarf können die Schichtdicken so modifiziert werden, dass für eine gegebene Wellenlänge eine maximale Transmission auftritt. Schichtdickentoleranzen um 10% haben nur noch marginalen Einfluss.

Nach dieser Schichtabscheidung erfolgt standardmäßig die Strukturierung von Bondpads. Wenn die Isolatorschicht aus Siliziumnitrid besteht und die darüber befindliche transparente leitfähige aus Indiumzinnoxid (ITO-Schicht), liegt der Fall vor, dass die Brechzahlen beider Schichten annähernd gleich sind, so dass die Dickenoptimierung des Doppelschichtsystems relativ einfach ist.

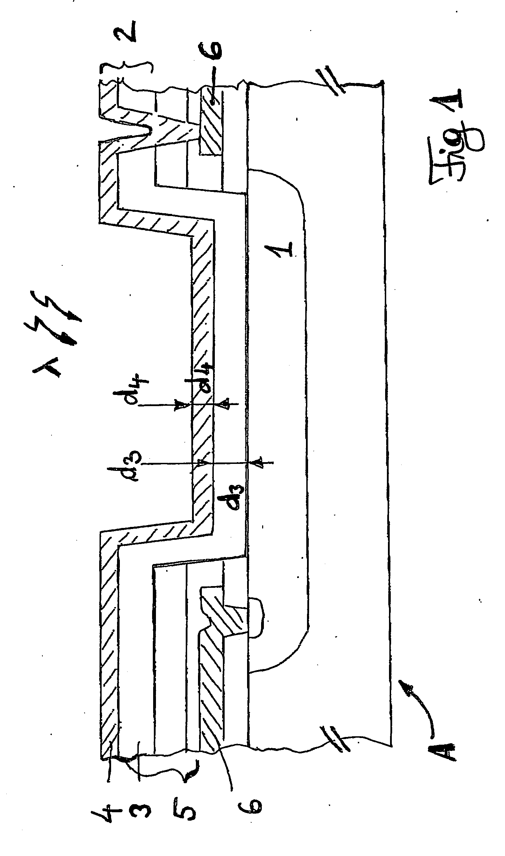

Ein Beispiel veranschaulicht die Erfindung mit Bezug auf die einzige Figur. Über den lichtempfindlichen Gebieten 1, insbesondere Fotodioden oder Fotogates, wird ein nur aus zwei Schichten 3, 4 bestehendes Schichtsystem 2 angeordnet, dessen optische Dicke (Brechzahl * Schichtdicke) auf die Wellenlänge abgestimmt wird. Die Transmission wird maximal, zumindest stark erhöht (D = λ/4 bzw. ein ungerades Vielfache davon) und eine unvermeidliche Toleranz der Dicke nach dem Abscheiden (i.A. ± 10%) führt noch nicht von einer Verstärkung zu einer Auslöschung des durchgehenden Lichtes (Transmission), durch die Schichtdicken 3, 4.

In der Fertigung sieht das so aus, dass der CMOS- bzw. BiCMOS-Prozess unverändert bis einschließlich der letzten Metallisierung 6 ablaufen kann. Ein üblicherweise danach abzuscheidendes Passivierungs-Schichtsystem 5 erhält mehrere Aufgaben: Eine elektrische Isolation zur Umwelt, einen mechanischen Schutz, einen Schutz gegenüber Feuchte und gegebenenfalls auch eine Getterwirkung (z.B. durch eingebauten Phosphor).

Beispielhaft wird von einem solchen Doppelschichtsystem 2 der Passivierung, mit einer ersten Schicht aus Siliziumoxinitrid, gefolgt von einer Schicht 3 aus Siliziumnitrid ausgegangen. In der Prozessfolge wird das Siliziumoxinitrid standardmäßig abgeschieden. Falls dieses gettern soll, können Getterzentren eingebracht werden. Danach erfolgt ein fotolithografischer Prozess, bei dem die lichtempfindlichen Gebiete 1 freigelegt werden. Dabei werden im Bereich der fotoempfindlichen Strukturen alle Schichten über der Siliziumoberfläche A entfernt, was bedingt durch Grenzfläche SiO₂/Si ausreichend präzise möglich ist.

Es versteht sich, dass Öffnungen der Fotomaske einen hinreichend großen Abstand zu Metall-Leitbahnen und zu an die Oberfläche stoßenden pn-Übergängen haben (pn-Übergänge dürfen nicht freigelegt werden).

Nach dem Entfernen der Lackmaske wird dann die das neue Passivierungssystem 2 komplettierende Siliziumnitridschicht 3 mit einer definierten Schichtdicke abgeschieden, die zu einer Dicke der später noch aufzubringenden transparenten elektrisch leitfähigen Schicht 4 passt.

Zunächst folgt die Öffnung der Kontakte in der Passivierungsschicht, für die Verbindung zwischen der oberen Metallschicht und der abschirmenden Schicht.

Nach - nicht dargestelltem - Öffnen der Kontakte folgt die Abscheidung der transparenten leitfähigen Schicht 4, gefolgt von deren - nicht dargestellten - Strukturierung. Die optische Dicke des Schichtsystems aus Passivierungsschicht 3 und transparenter leitfähiger Schicht 4 wird in an sich bekannter Weise so gewählt, dass für einen gegebenen Lichtwellenlängenbereich eine hohe, insbesondere maximale Transmission auftritt.

Bei Bedarf können die Schichtdicken d3, d4 so modifiziert werden, dass für eine gegebene Wellenlänge λ eine maximale Transmission auftritt.

Schichtdickentoleranzen um 10% haben nur noch marginalen Einfluss.

Nach dieser Schichtabscheidung erfolgt standardmäßig eine Strukturierung von Bondpads, die nicht gesondert dargestellt ist. Wenn die Isolatorschicht 3 aus Siliziumnitrid besteht und die darüber befindliche transparente, leitfähige Schicht 4 aus Indiumzinnoxid (ITO-Schicht) können die Brechzahlen beider Schichten 3, 4 als System 2 annähernd gleich sein, so dass die Dickenoptimierung des Doppelschichtsystems 2 relativ einfach ist.

### Bezugszeichenliste

- 1: lichtempfindliche, zu schützende Gebiete
- 2: Schichtsystem, bestehend aus Schicht 3 und 4
- 3: letzte Schicht des Passivierungssystems
- 5: Passivierungssystem
- 6: Metallisierung
- d₃: optische Dicke der letzten Passivierungsschicht (Dicke * Brechzahl)
- d₄: optische Dicke der transparenten leitfähigen Schicht (Dicke * Brechzahl)
- d: (n₃ * d₃) + (n₄ * d₄) = optische Dicke des Systems der Schichten 3 und 4.

## Patentansprüche

1. Verfahren zur Herstellung von integrierten Schaltungen in CMOS/BiCMOS-Technologie mit integrierten fotoempfindlichen Strukturen auf einer Siliziumscheibe, insbesondere Fotodioden oder Fotogates, mit einer elektrischen Abschirmung, wobei zur Passivierung der Schaltungen nach einer letzten Metallisierungsschicht oder -ebene (6) ein System (5) aus mehreren Schichten aufgebracht wird,
- wobei alle Schichten des entsprechenden Passivierungs-Schichtsystems (5) mit Ausnahme einer letzten Schicht (3) auf der Scheibe (A) abgeschieden werden, danach Gebiete über den lichtempfindlichen Strukturen (1) mit einem fotolithografischen Prozess durch Beseitigung aller über dem Silizium liegenden Schichten geöffnet werden;
- die letzte passivierende Schicht (3) des Passivierungssystems (5) mit einer der optischen Dicke (d₄) einer später abgeschiedenen transparenten, elektrisch leitfähigen Schicht (4) angepassten Dicke (d₃) aufgebracht wird;
- wobei zusammen genommen für das Schichtsystem (2) aus letzter Passivierungsschicht (3) und der transparenten, elektrisch leitfähigen Schicht (4) eine optische Dicke (d₃ + d₄) maximaler Transparenz entsteht;
- wobei im Passivierungs-Schichtsystem (2,5) Kontakte für eine Verbindung zwischen der oberen Metallschicht (6) und der abschirmenden Schicht (4) geöffnet werden;
- die Abscheidung der transparenten, elektrisch leitfähigen Schicht (4) vorgenommen wird und anschließend strukturiert wird und schließlich Bondpads geöffnet werden.

2. Verfahren nach Anspruch 1, wobei das Schichtsystem aus Passivierungsschicht und transparenter, elektrisch leitfähiger Schicht aus einer Siliziumnitridschicht (3) und einer Indiumzinnoxidschicht (4) besteht.

3. Verfahren nach Anspruch 1, und wobei das Schichtsystem aus Passivierungsschicht und transparenter, elektrisch leitfähiger Schicht aus einer Siliziumoxidschicht (3) und einer Indiumzinnoxidschicht (4) besteht.

4. Verfahren nach Anspruch 1, wobei nicht mehr als zwei Schichten (3,4) über dem lichtempfindlichen Gebiet (1) gelegen sind, bei fertigem IC.

5. Verfahren nach Anspruch 1, wobei die letzte Schicht aus ITO ist.

## Claims

1. Process for producing integrated circuits according to CMOS/BiCMOS technology with integrated photo-sensitive structures on a silicon chip, in particular photodiodes or photogates, with electrical shielding, wherein for passivation of the circuits after a final metallisation layer or metallisation plane (6), a system (5) of several layers is applied,
- wherein all layers of the corresponding passivation layer system (5) with the exception of a final layer (3) are deposited on the chip (A), then areas over the light-sensitive structures (1) are opened using a photolithographic process by eliminating all layers lying above the silicon;
- the final passivation layer (3) of the passivation system (5) is applied with a thickness (d₃) adapted to the optical thickness (d₄) of a transparent, electrically conductive layer (4) deposited later;
- wherein taken together for the layer system (2) comprising final passivation layer (3) and the transparent, electrically conductive layer (4), an optical thickness (d₃ + d₄) of maximum transparency is produced;
- wherein in the passivation layer system (2, 5), contacts for a connection between the upper metal layer (6) and the shielding layer (4) are opened;
- deposition of the transparent, electrically conductive layer (4) is carried out and then is structured and finally bond pads are opened.

2. Process according to claim 1, wherein the layer system consists of passivation layer and transparent, electrically conductive layer comprising a silicon nitride layer (3) and an indium tin oxide layer (4).

3. Process according to claim 1, and wherein the layer system consists of passivation layer and transparent, electrically conductive layer comprising a silicon oxide layer (3) and an indium tin oxide layer (4).

4. Process according to claim 1, wherein not more than two layers (3, 4) are placed over the light-sensitive area (1) for the finished IC.

5. Process according to claim 1, wherein the final layer is made from ITO.

## Revendications

1. Procédé de production de circuits intégrés dans la technologie CMOS/BiCMOS avec des structures photosensibles intégrées sur une tranche de silicium, notamment des photodiodes ou des photogrilles, avec un blindage électrique, dans lequel, pour la passivation des circuits, on dépose après une dernière couche ou un dernier plan de métallisation (6) un système (5) constitué de plusieurs couches,
- où toutes les couches du système stratifié de passivation (5) correspondant, à l'exception d'une dernière couche (3), sont déposées sur la tranche (A), après quoi des zones au-dessus des structures photosensibles (1) sont ouvertes grâce à un procédé photolithographique par suppression de toutes les couches se trouvant au-dessus du silicium ;
- la dernière couche passivante (3) du système de passivation (5) est déposée en une épaisseur (d₃) adaptée à une épaisseur optique (d₄) d'une couche (4) transparente, conductrice électriquement, déposée ultérieurement ;
- où, pour l'ensemble du système stratifié (2) constitué de la dernière couche de passivation (3) et de la couche (4) transparente électriquement conductrice, il apparaît une épaisseur optique (d₃ + d₄) de transparence maximale ;
- où, dans le système stratifié de passivation (2, 5), des contacts sont ouverts pour une connexion entre la couche métallique supérieure (6) et la couche de blindage (4) ;
- le dépôt de la couche (4) transparente électriquement conductrice est opéré et, ensuite, elle est structurée et enfin, des plots de connexion sont ouverts.

2. Procédé selon la revendication 1, dans lequel le système stratifié se compose d'une couche de passivation et d'une couche transparente électriquement conductrice, constituées d'une couche de nitrure de silicium (3) et d'une couche d'oxyde d'étain indium (4).

3. Procédé selon la revendication 1, dans lequel le système stratifié se compose d'une couche de passivation et d'une couche transparente électriquement conductrice, constituées d'une couche d'oxyde de silicium (3) et d'une couche d'oxyde d'étain indium (4).

4. Procédé selon la revendication 1, dans lequel pas plus de deux couches (3,4) sont placées sur la zone photosensible (1), dans le CI fini.

5. Procédé selon la revendication 1, dans lequel la dernière couche est en ITO.
